# EUROPÄISCHE PATENTSCHRIFT

(11) **EP 0 354 523 B1**
(45) Veröffentlichungstag und Bekanntmachung des Hinweises auf die Patenterteilung: **03.02.1993**
(21) Anmeldenummer: 89114605.2
(22) Anmeldetag: 08.08.1989
(51) Int. Cl.: H03J 9/06, H04N 5/63, G08C 23/00

(54) **Fernbedienung für ein mit Schaltnetzteil ausgerüstetes elektronisches Gerät**
Remote control for an electronic apparatus with switching power supply
Commande à distance pour un appareil électronique à alimentation de puissance à découpage

(30) Priorität: 11.08.1988 DE 3827210
(43) Veröffentlichungstag der Anmeldung: 14.02.1990
(73) Patentinhaber: GRUNDIG E.M.V. Elektro-Mechanische Versuchsanstalt Max Grundig holländ. Stiftung & Co. KG., D-90762 Fürth (DE)
(72) Erfinder: Rohrbacher, Josef c/o Grundig E.M.V., Kurgartenstrasse 37 D-8510 Fürth (DE); Rosenberger, Winfried c/o Grundig E.M.V., Kurgartenstrasse 37 D-8510 Fürth (DE)

(56) Entgegenhaltungen:
- EP-A- 0 211 554
- DE-A- 3 601 738
- GB-A- 2 162 978
- GB-A- 2 164 814

## Beschreibung

Die Erfindung betrifft eine intelligente Fernbedienung für ein elektronisches Gerät, insbesondere für ein Fernsehgerät.

Aus der Zeitschrift Funkschau 1980, Heft 22, Seiten 76 bis 83 und Heft 23, Seiten 93 bis 94, ist ein Fernsehgerät bekannt, welches mit einer Infrarot-Fernbedienung ausgerüstet ist. Das bekannte Fernsehgerät weist weiterhin ein Multiprozessorsystem mit einem Hauptprozessor (Master-CPU) und einem Hilfsprozessor (Slave-CPU) auf, welche im Handshaking-Betrieb arbeiten. Der Hilfsprozessor hat die Aufgabe, die Schaltkreise PLL und IR-Empfänger zu steuern, während der Hauptprozessor die serielle Ausgabe für den Bildschirmtext-/Videotext-Decoder und die Anzeige steuert.

In der DE-A- 36 01 738 ist ein Schaltnetzteil für ein fernbedienbares Gerät, insbesondere für ein Fernsehgerät, beschrieben, bei dem das Fernbedienempfangsteil netzseitig, also innerhalb der Netzstromkreise angeordnet ist. Die Ein- und Aus-Funktion wird dabei durch Steuerung der Schutzschaltung für den Schalttransistor der ebenfalls in den Netzstromkreisen liegenden Ansteuerung des Schaltnetzteils durchgeführt, während die Steuersignale für alle anderen Funktionen über einen Optokoppler in die netzgetrennten Betriebsstromkreise zur weiteren Verarbeitung in einem Mikroprozessor übertragen werden.

Da der Mikroprozessor in einem Fernsehgerät die zentrale Steuerung verschiedenster Funktionen, also auch solcher Funktionen, die nicht die Fernsteuerung betreffen, übernimmt, hat die Fernbedienung nach dem Stand der Technik den Nachteil, daß die vom Fernbedienempfänger eintreffenden Signale nicht ökonomisch in das Rechenprogramm eingefügt werden können. Es tritt auch die Schwierigkeit auf, daß diese eintreffenden Signale asynchron zum internen Takt des Mikroprozessors sind. Es müssen also geeignete Pufferspeicher zur Verfügung stehen oder es muß ein besonderer Mikroprozessor nur für die Fernbedienfunktionen bereitgestellt werden.

Ein weiterer Nachteil des aus der DE-A- 36 01 738 bekannten Gerätes besteht darin, daß ein Einschalten des Gerätes aus dem Bereitschaftsbetrieb und ein Ausschalten des Gerätes vom Normal- in den Bereitschaftsbetrieb nur mittels des Fernbedieriungsgebers möglich ist und beim Einschalten des Gerätes vom Bereitschaftsbetrieb in den Normalbetrieb zwei Tasten betätigt werden müssen und zwar zunächst die Ein-Taste und dann die Senderwahltaste.

Ausgehend von diesem Stand der Technik ist es Aufgabe der Erfindung, einen Weg aufzuzeigen, wie die Ein- und Ausschaltmöglichkeiten des Gerätes vom bzw. in den Bereitschaftsbetrieb verbessert werden können.

Diese Aufgabe wird bei einer Fernbedienung mit den im Oberbegriff des Anspruchs 1 angegebenen Merkmalen durch die im kennzeichnenden Teil des Anspruchs 1 angegebenen Merkmale gelöst.

Ein Vorteil dieser Lösung besteht darin, daß der Zentralprozessor andere, nicht die Fernbedienung betreffende Aufgaben besser erfüllen kann.

Wie beim vorbekannten Stand der Technik wird der Einschaltbefehl vom Fernbedienempfänger innerhalb der Netzstromkreise ohne galvanische Trennung an das Schaltnetzteil weitergegeben. Im Bereitschaftsbetrieb ist das Schaltnetzteil stromlos, das heißt, die Verlustleistung im Bereitschaftsbetrieb ist nur durch die Leistungsaufnahme des Fernbedienempfängers und des zugeordneten Hilfsprozessors, die über eine entsprechende Gleichrichter- und gegebenenfalls Regelschaltung direkt aus dem Netz gespeist werden, bestimmt. Diese Verlustleistung ist sehr gering, insbesondere wesentlich geringer als bei konventionellen Konzepten, bei denen das Schaltnetzteil im Bereitschaftsbetrieb mit reduzierter Leistung weiterläuft. Darüber hinaus ist es auch aus Sicherheitsgründen insbesondere wegen Brandgefahr vorteilhaft, das Schaltnetzteil im Bereitschaftsbetrieb völlig stillzulegen.

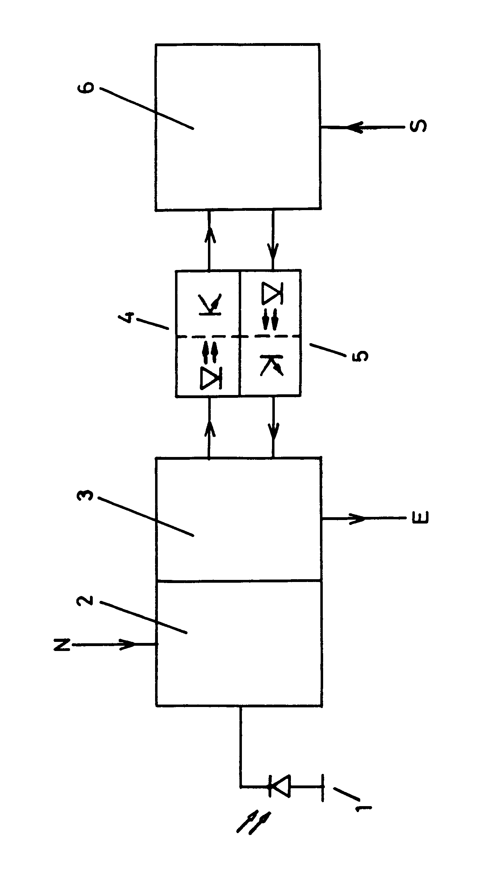

Zur Verdeutlichung der Erfindung wird nachstehend der Funktionsablauf beim Einschalt- und Bedienvorgang mit Hilfe der einzigen Figur näher erläutert

Der Infrarotsensor 1 empfängt ein Signal, das vom Fernbedienungsgeber abgestrahlt und entsprechend der Befehlseingabe moduliert ist. Der Befehl kann lauten, es soll ein bestimmtes Fernsehprogramm empfangen werden. Die Vorverstärkung und Aufbereitung des Empfangssignals erfolgt im Empfänger 2, der über die Leitung N innerhalb der Netzstromkreise über einen nicht dargestellten Gleichrichter mit gegebenenfalls nachgeschaltetem Spannungsregler stromversorgt wird. Das aufbereitete Fernsteuersignal wird an den Hilfsprozessor 3 weitergegeben, der auf die gleiche Weise stromversorgt wird und gegebenenfalls mit dem Empfänger 2 baulich vereinigt sein kann. Die Stromversorgung über die Leitung N ist so lange aktiv, wie der am Netzeingang des Fernsehempfängers vorgesehene zweipolige Hauptschalter eingeschaltet ist. Der Hilfsprozessor 3 verarbeitet das decodierte Fernsteuersignal und gibt in jedem Fall über die Leitung E einen Befehl aus, der das Schaltnetzteil in Betrieb setzt. Das Schaltnetzteil liefert sodann die Stromversorgung für die Betriebsstromkreise, unter anderem über die Leitung S auch die Stromversorgung für den Zentralprozessor 6. Nach Abschluß der Einlaufphase erkennt der Zentralprozessor an dem über den Optokoppler 4 angelieferten Datensignal, daß ein Fernbedienungsbefehl im Hilfsprozessor 3 angekommen und abrufbereit ist. Danach kann über die Optokoppler 4 und 5 ein bidirektionaler Datenaustausch zwischen dem Zentralprozessor 6 und dem Hilfsprozessor 3 erfolgen. Der im Hilfsprozessor vorliegende Befehl wird auf Plausibilität geprüft und weiterverarbeitet oder gelöscht. Die sichere Trennung der Netz- und Betriebsstromkreise wird durch die optische Übertragungsstrecke erreicht und ist in der Figur durch die gestrichelten Linien angedeutet.

Solange keine Fernbedienbefehle vorliegen, ist der Zentralprozessor frei für andere Aufgaben innerhalb des Gerätes wie z.B. die automatische Steuerung der Video-, Audio-, ZF- und Ablenkstufen nach Maßgabe vorgegebener, im zugehörigen Speicher abgelegter Daten.

## Patentansprüche

1. Fernbedienung für ein elektronisches Gerät, insbesondere für ein Fernsehgerät, bei dem die Stromversorgung und die Trennung der Netzstromkreise von den Betriebsstromkreisen durch ein geregeltes Schaltnetzteil erfolgt und der Fernbedienempfänge (1,2) für die drahtlos von einem Fernbediengeber übertragenen Fernbediensignale innerhalb der Netzstromkreise liegt und die Fernbedienungsbefehle über einen Optokoppler (4) in einen innerhalb der netzgetrennten Betriebsstromkreise liegenden Zentralprozessor (6) überführt werden,
**dadurch gekennzeichnet**, daß ein weiterer Optokoppler (5) vorgesehen ist, der eine Übertragung von Daten in Gegenrichtung vom in den Betriebsstromkreisen liegenden Zentralprozessor (6) zum in den Netzstromkreisen liegenden Fernbedienempfänger (1, 2) erlaubt und daß der Fernbedienempfänger mit einem Hilfsprozessor (3) ausgerüstet ist, der über die bidirektionale Optokopplerverbindung (4, 5) mit dem Zentralprozessor kommuniziert.

## Claims

1. Remote control unit for an electronic device, in particular for a television set, in which the power supply and the isolation of the mains circuits from the operating circuits is handled by a regulated switched-mode power supply, and the remote control receiver (1, 2) for the remote control signals radio-transmitted from a remote control transmitter is located within the mains circuits, and the remote control commands are transferred via an optocoupler (4) into a central processor (6) located within the mains-isolated operating circuits, characterised in that a further optocoupler (5) is provided which permits data to be transmitted in the opposite direction from the central processor (6) located in the operating circuits to the remote control receiver (1, 2) located in the mains circuits, and in that the remote control receiver is equipped with a slave processor (3) which communicates with the central processor via the bidirectional optocoupler connection (4, 5).

## Revendications

1. Télécommande pour un appareil électronique, en particulier un récepteur de télévision, dans laquelle l'alimentation en courant et la séparation des circuits alimentés par le courant du secteur des circuits alimentés par le courant de fonctionnement sont obtenues au moyen d'un bloc d'alimentation secteur régulé et commuté, et dans laquelle le récepteur de télécommande (1, 2) pour les signaux de télécommande transmis sans fil par un émetteur de télécommande est situé parmi les circuits alimentés par le courant du sectéur et dans laquelLe les signaux de télécommande sont envoyés par l'intermédiaire d'un opto-coupleur (4) à un processeur central (6) situé parmi les circuits alimentés par le courant de fonctionnement et isolés du secteur,
caractérisée en ce qu'un deuxième opto-coupleur (5) est prévu qui permet une transmission de données en sens inverse depuis le processeur central (6) situé parmi les circuits alimentés par le courant de fonctionnement vers le récepteur de télécommande (1, 2) situé parmi les circuits alimentés par le secteur, et que le récepteur de télécommande est muni d'un processeur auxiliaire (3) qui communique avec le processeur central par l'intermédiaire de la liaison bidirectionnelle par opto-coupleur (4, 5).
